Europäisches Patentamt

**European Patent Office**

**Office européen des brevets**

(11) Numéro de publication: **0 448 739 B1**

(12) **FASCICULE DE BREVET EUROPEEN**

(45) Date de publication de fascicule du brevet: **01.06.94**  (51) Int. Cl.5: **A23L  3/54**, A23C 19/086,
A23C 13/12

(21) Numéro de dépôt: **90105636.6**

(22) Date de dépôt: **24.03.90**

Le dossier contient des informations techniques présentées postérieurement au dépôt de la demande et ne figurant pas dans le présent fascicule.

(54) **Procédé de déshydratation d'un produit à base de matières grasses.**

(43) Date de publication de la demande:
**02.10.91 Bulletin  91/40**

(45) Mention de la délivrance du brevet:
**01.06.94 Bulletin  94/22**

(84) Etats contractants désignés:
**AT BE CH DE DK ES FR GB GR IT LI LU NL SE**

(56) Documents cités:
**FR-A- 2 077 976**
**GB-A- 2 073 574**
**GB-A- 2 176 088**
**GB-A- 2 209 265**
**US-A- 3 431 119**

**PATENT ABSTRACTS OF JAPAN, vol. 10, no. 36 (C-328)[2093], 13 février 1986;& JP-A-60 186 267 (HAUSU SHIYOKUHIN KOGYO) 21-09-1985**

**FOOD SCIENCE & TECHNOLOGY ABSTRACTS, no.75002156 (75-01-J0101); R. HUET: "Aroma retention in tropical fruit powders obtained in a vacuum microwave oven", & FRUITS, vol. 29, no. 5, p. 399-405 (1974)**

(73) Titulaire: **SOCIETE DES PRODUITS NESTLE S.A.**
**Case postale 353**
**CH-1800 Vevey(CH)**

(72) Inventeur: **Thomas, Remi**
**11, rue Neuve**
**F-60390 Berneuil en Bray(FR)**

**Description**

La présente invention est relative à un procédé de déshydratation d'un produit à base de matières grasses destiné à être réhydraté.

La présente invention a plus particulièrement pour objet un procédé de déshydratation d'un produit alimentaire à base de matières grasses destiné à être réhydraté dans lequel le dit produit est traité par microondes sous pression réduite.

Les procédés de déshydratation des produits alimentaires par microondes sous pression réduite sont connus pour être à l'origine de l'apparition de phénomènes d'arcs électriques à l'intérieur du dispositif à microondes qui, d'une part, détériorent l'installation, et, d'autre part, dénaturent le produit à traiter.

Pour résoudre ces problèmes, il a été proposé, par exemple par le document GB-A-2.209.265, un procédé dans lequel le produit alimentaire à déshydrater est placé dans un bain d'huile à l'intérieur d'une enceinte où règne une pression réduite de 2660 Pa, le produit subissant un traitement par microondes.

Dans ce document, qui décrit de nombreux exemples dans lesquels le produit alimentaire à traiter est constitué de pommes, il est par ailleurs mentionné qu'il est possible de déshydrater de nombreux autres produits alimentaires tels que, par exemple, des fromages.

Or, il est apparu que si on désire obtenir une matière grasse déshydratée par ce procédé il y a une double diffusion de l'huile dans la matière grasse à traiter d'une part et de certains éléments de la matière grasse dans l'huile d'autre part.

Ainsi, si on obtient effectivement une matière grasse déshydratée par ce procédé, le produit final obtenu est trop dénaturé par rapport au produit d'origine pour permettre une utilisation ultérieure dans des produits culinaires.

Il est également connu, par le document JP 60-186267, un procédé permettant la déshydratation de produits alimentaires tout en évitant le grillage de la couche superficielle dudit produit, en ajoutant audit produit une substance inhibitrice de l'accumulation de la matière grasse.

Des essais ont donc été réalisés par la demanderesse pour la déshydratation de produits à base de matières grasses dans des installations à microondes en n'utilisant pas de bains d'huile.
Ces essais ont mis en évidence de nombreux problèmes.

Plus particulièrement, quand la matière grasse est traitée sous forme de morceaux de quelques millimètres d'épaisseur, par exemple lorsqu'il s'agit de fromage râpé, le produit s écoule difficilement ce qui rend les opérations de dosage délicates et cela d'autant plus que la taille des morceaux est plus réduite. Il est ainsi apparu que ce phénomène devient particulièrement crucial pour les morceaux dont la plus grande dimension est inférieure à deux millimètres, la matière grasse ayant alors tendance à se prendre en masse empêchant ainsi un écoulement satisfaisant.

En outre, lors de la déshydratation par microondes, les matières grasses ont tendance à fondre ce qui provoque une forte exsudation du produit à traiter, la majeure partie des matières grasses fondues étant ensuite réabsorbée par le produit lors du refroidissement.
Ainsi, lors de l'extraction du produit final déshydraté, les morceaux qui le constituent se sont agglomérés ce qui nécessite un broyage supplémentaire du produit.
Or, pour éviter une nouvelle fusion des matières grasses lors de ce broyage, celui-ci doit être effectué à très basse température, sous azote liquide. Le broyage est donc très difficile à réaliser.

La présente invention a donc pour but de proposer un procédé de déshydratation d'un produit à base de matières grasses par microondes qui résout ces problèmes.

La présente invention a donc pour objet un procédé de déshydratation d'un produit à base de matières grasses selon les revendications 1 à 6.

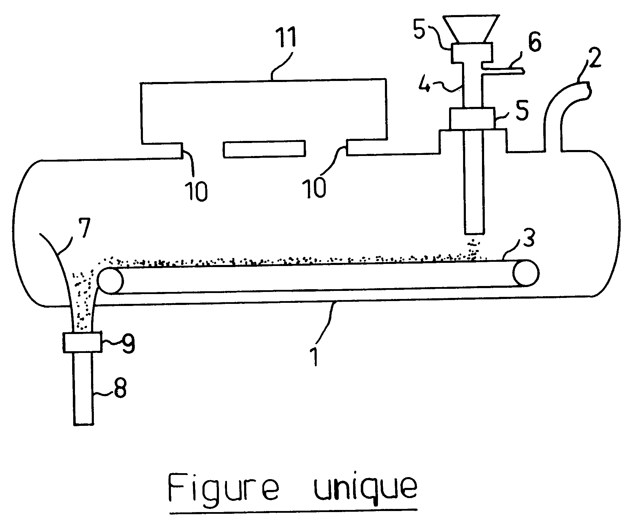

Les caractéristiques et avantages de l'invention ressortiront à la suite de la description qui va suivre faite en référence à la figure unique donnée uniquement à titre d'exemple qui représente une installation de déshydratation par microondes pour la mise en oeuvre du procédé selon l'invention.

Comme illustré à la figure unique, une installation pour la mise en oeuvre du procédé selon l'invention présente un four à microondes constitué d'une enceinte cylindrique 1, reliée à une source de vide 2, dans laquelle défile un tapis 3 sur lequel est déposé le produit à déshydrater.

L'introduction du produit dans l'enceinte 1 du four peut être réalisée par un sas 4 constitué par un cylindre obturé à chaque extrémité par exemple par une vanne à tiroir 5.

Un système de mise sous vide 6 de ce sas 4 permet l'introduction de charges successives de produit dans l'enceinte 1 du four, à l'une des extrémités du tapis 3.

A l'autre extrémité du tapis 3, le produit déshydraté, par le biais d'une trémie 7, tombe dans un réservoir 8 auquel elle est reliée par une vanne 9.

EP 0 448 739 B1

L'enceinte 1 reçoit le rayonnement de microondes par une ou plusieurs fenêtres 10 reliées à un générateur de microondes 11.

Le procédé selon la présente invention peut être ou non précédé d'un prétraitement du produit à base de matières grasses à traiter.

Par ailleurs, tout produit à base de matières grasses peut être utilisé, il peut s'agir ainsi d'une crème fraîche ou d'un fromage frais ou cuit, et plus particulièrement d'un gruyère ou d'un emmental.

Quoi qu'il en soit, il a été trouvé que l'adjonction, au produit à traiter, d'une substance support apte à absorber la matière grasse exsudée à la surface du produit à traiter, d'une part, permet d'augmenter la fluidité du produit avant traitement par microondes, quand celui-ci est constitué de fromage râpé par exemple, et, d'autre part et quelque soit la nature exacte du produit à base de matières grasses, évite une reprise en masse du produit, après traitement par microondes, en absorbant la matière grasse qui a été exsudée lors du dit traitement par microondes.

Selon la destination finale du produit, la substance support peut être choisie parmi les substances amylacées ou les caséinates.

De plus, et dans le cas de la déshydratation d'un produit solide tel qu'un fromage râpé du type emmental, il a été trouvé que la taille des particules constituant le produit à traiter avait une grande influence sur la température de séchage dans l'installation microondes, et, de la sorte, sur l'exsudation de matières grasses lors du séchage par microondes.

Plus particulièrement, des tests ont été effectués sur un fromage râpé de type emmental.

Lors de ces tests, le débit du produit était fixé à 12 kg/h, la puissance du four microondes était de 4,1 kW, le temps de séchage de 60 minutes, et la pression dans l'enceinte du four de 1066 Pa.

Le résultat de ces tests est résumé dans le tableau 1 ci-dessous, la température étant mesurée par un pyromètre infrarouge, MS signifiant matière sèche.

## Tableau 1
### Influence de la granulométrie sur le séchage

| Granulométrie | teneur en MS initiale | puissance microondes | température infrarouge | teneur en MS finale |
|---|---|---|---|---|
| morceaux 1 mm | 67,11 | 4,1 | 64 | 96,66 |
| morceaux 2 mm | 67,11 | 4,1 | 71 | 95,96 |
| morceaux 5 mm | 67,11 | 4,1 | 81 | 96,36 |

Les températures indiquées par le pyromètre infrarouge ont été vérifiées en introduisant des papiers thermosensibles dans la couche de produit. Les valeurs relevées sont légèrement plus fortes mais les écarts de température entre les différents essais subsistent.

Il apparaît ainsi clairement que la température de séchage dépend fortement de la granulométrie. Pour les particules de grosse taille, le départ de l'eau étant plus difficile, il y a accumulation d'énergie.

Une faible granulométrie, en abaissant la température de séchage, diminue donc les phénomènes d'exsudation lors du séchage, en revanche, elle tend à rendre l'écoulement du produit avant séchage plus difficile, comme déjà exposé ci-dessus. De plus, l'abaissement de la température de séchage obtenu n'est pas suffisant pour supprimer totalement les phénomènes d'exsudation.

L'utilisation d'une substance support, en permettant un meilleur écoulement du produit, pallie cet inconvénient et, par ailleurs, une faible granulométrie, en diminuant les phénomènes d'exsudation, par abaissement de la température de séchage, réduit la quantité de substance support nécessaire.

La combinaison d'une substance support et d'un produit de faible granulométrie permet ainsi l'obtention d'un résultat remarquable.

Un prétraitement consistant en une réduction de la granulométrie du produit à traiter peut donc être avantageusement réalisé.

3

Un autre paramètre important qui détermine la qualité de la déshydratation obtenue est la pression régnant dans l'enceinte du four à microondes. Pour cela des tests ont été réalisés dans lesquels le débit de produit à traiter était fixé à 12 kg/h, la granulométrie était de 1 mm, la puissance du four à microondes de 4,2 kW, le temps de séjour de 60 mn et la teneur en matière sèche initiale de 66,22%, le produit étant un emmental.

Au cours de ces tests, ont été mesurées la température, les activités de l'eau au cours de la déshydratation et à la fin du processus, ainsi que les teneurs en matières sèches finales.

Les résultats sont résumés au tableau 2 ci-dessous.

## Tableau 2
## Influence de la pression sur le séchage

| Pression dans l'enceinte | | Température du produit °C | Activité de l'eau en surface du produit en cours de déshydratation | Activité de l'eau mesurée à 25°C après déshydra- tation | Teneur en matière sèche finale | Eau évaporée par kW |
|---|---|---|---|---|---|---|
| mm Hg | Pascals | | | | | |
| 8 | 1066 | 60 | 0,055 | 0,30 | 96,8 | 0,903 |
| 14 | 1866 | 61 | 0,089 | 0,39 | 95,91 | 0,889 |
| 20 | 2666 | 66 | 0,102 | 0,46 | 95,46 | 0,875 |

Il apparaît ainsi clairement que l'influence de la pression sur la température de séchage, et donc sur l'exsudation, est importante, particulièrement en passant de 2666 Pa à 1866 Pa. Préférablement, la température de séchage sera choisie inférieure à 60°C. De plus, en favorisant la désorption de l'eau du produit, la diminution de la pression améliore la teneur en matière sèche finale en augmentant la quantité d'eau évaporée par kW.

On note un écart important entre le calcul de l'activité de l'eau du produit en cours de séchage et la mesure après séchage qui est dû au mauvais transfert de l'eau dans le produit. La migration de l'eau à l'intérieur des particules est mauvaise, ce qui explique encore une fois le rôle important de la granulométrie au cours du séchage de l'emmental.

La pression minimum a été fixée à 8 mm Hg, 1066 Pa, afin d'éviter l'apparition d'arcs électriques.

Les exemples suivants illustrent l'application du procédé selon l'invention à divers produits à base de matières grasses.

Exemple 1

Une crème à 35% de matière grasse est introduite dans l'enceinte d'un four microondes où règne une pression réduite de 1066 Pa.

Pour éviter l'exsudation de la matière grasse, il est ajouté une substance support à raison de 5% en poids.

Différents essais ont été réalisés en utilisant un amidon de maïs ou un caséinate de sodium.

La température de séchage est fixée à 42°C.

Le produit final obtenu présente 70% de matière grasse sur matière sèche.

Exemple 2

De l'emmental est broyé à une granulométrie de 0,5 mm dans un bol à couteaux d'une capacité de 80 l, en introduisant l'emmental en morceaux de 0,2 à 0,5 kg.

La vitesse de rotation des couteaux est maintenue à 250 tours /mn pendant une minute pour éviter les projections puis est portée à 3000 tours/mn pendant quatre minutes.

L'adjonction de fécule est réalisée après deux minutes à hauteur de 10% en masse par rapport au poids de l'emmental.

Les conditions de déshydratation sont les suivantes :
- Débit d'entrée dans l'enceinte du four : 90 kg/h
- Temps de séjour dans le four : 80 mn
- Pression dans l'enceinte : 10 mm Hg
- Puissance du four : 27 kw
- Teneur en matières sèches du produit : 67%
- Température infrarouge : 50°C±3°C

La teneur en matières sèches après déshydratation a été de 96%.

Exemple 3

Un emmental préparé de la même façon que dans l'exemple 2 a été introduit dans une enceinte d'un four à microondes dont les paramètres de fonctionnement sont les suivants :
- Débit d'entrée : 114 kg/h
- Temps de séjour dans le four : 110 mn
- Pression dans l'enceinte : 10 mm Hg
- Puissance du four : 27 kw
- Teneur en matières sèches du produit : 69%
- Température infrarouge : 44°C±2°C

La teneur en matières sèches après déshydratation a été de 98%.

Dans les trois exemples ci-dessus, il a donc été possible d'obtenir une déshydratation satisfaisante en obtenant un produit final non dénaturé par rapport au produit initial tout en évitant une reprise en masse du produit lors du refroidissement suivant la déshydratation.

La limitation de la température infrarouge à 50°C au maximum a permis de limiter les phénomènes d'exsudation et de réduire la quantité de substance support nécessaire.

Par ailleurs les tests de conservation qui ont été réalisés montrent une durée de conservation au moins égale à celle obtenue par les procédés classiques de lyophilisation ou de pulvérisation.

**Revendications**

**1.** Procédé de déshydratation d'un produit à base de matières grasses dans lequel le produit est additionné d'une substance support apte à absorber la matière grasse exsudée, choisie dans le groupe constitué par les substances amylacées et les caséinates, puis le produit est placé dans une enceinte à microondes sous une pression réduite.

**2.** Procédé selon la revendication 1 dans lequel la déshydratation est réalisée à une pression comprise entre 1066 Pa et 2666 Pa.

**3.** Procédé selon la revendication 2 dans lequel le produit a une granulométrie d'au plus 1 mm.

**4.** Procédé selon l'une des revendications précédentes dans lequel la température infrarouge mesurée dans l'enceinte à microondes est inférieure à 60°C.

**5.** Application du procédé selon l'une des revendications précédentes à la déshydratation d'un emmental.

**6.** Application du procédé selon l'une des revendications précédentes à la déshydratation d'une crème fraîche.

**Claims**

1. A process for the dehydration of a product based on fats, in which a supporting substance capable of absorbing the fats exuded - selected from the group of amylaceous substances and caseinates - is added to the product after which the product is placed in a microwave enclosure under reduced pressure.

2. A process as claimed in claim 1, in which dehydration is carried out under a pressure of 1066 Pa to 2666 Pa.

3. A process as claimed in claim 2, in which the product has a particle size of at most 1 mm.

4. A process as claimed in any of the preceding claims, in which the infrared temperature measured in the microwave enclosure is below 60°C.

5. The application of the process claimed in any of the preceding claims to the dehydration of Emmental.

6. The application of the process claimed in any of the preceding claims to the dehydration of fresh cream.

**Patentansprüche**

1. Verfahren zur Dehydratisierung eines fetthaltigen Produkts, bei dem dem Produkt eine Trägersubstanz beigegeben wird, die das ausgeschwitzte Fett absorbieren kann und aus der Gruppe der Stärkesubstanzen und Caseinate ausgewählt ist, und das Produkt anschließend in eine Mikrowellenkammer unter vermindertem Druck eingebracht wird.

2. Verfahren nach Anspruch 1, bei dem die Dehydratisierung unter einem Druck von 1066 und 2666 Pa durchgeführt wird.

3. Verfahren nach Anspruch 2, bei dem das Produkt eine Korngröße von höchstens 1 mm hat.

4. Verfahren nach einem der vorhergehenden Ansprüche, bei dem die in der Mikrowellenkammer gemessene Infrarottemperatur weniger als 60° C beträgt.

5. Anwendung des Verfahrens nach einem der vorhergehenden Ansprüche auf die Dehydratisierung von Emmentaler.

6. Anwendung des Verfahrens nach einem der vorhergehenden Ansprüche auf die Dehydratisierung von creme-fraiche.

Figure unique